# EUROPEAN PATENT APPLICATION

(11) **EP 4 447 245 A1**
(43) Date of publication of application: **16.10.2024**
(21) Application number: 24166686.6
(22) Date of filing: 27.03.2024
(51) Int. Cl.: H02H 3/20, H02H 3/087, F21V 23/00, H03K 17/082

(54) **A LATCH PROTECTION SWITCH AND A POWER RAIL PROTECTION CIRCUIT HAVING THE SAME**

(30) Priority: 30.03.2023 CN 202310361368
(71) Applicant: Self Electronics Co., Ltd., Ningbo City, Zhejiang 315103 (CN); Lin, Wanjiong, Ningbo City, Zhejiang 315103 (CN); SELF ELECTRONICS Germany GmbH, 51149 Köln (DE)
(72) Inventor: WANG, Ke, Ningbo 315103 (CN); Qu, Yang, Ningbo 315103 (CN); CHEN, Dong, Ningbo 315103 (CN)
(74) Representative: 2K Patentanwälte Blasberg Kewitz & Reichel

(57) **Abstract**

The present invention provides a latch protection switch and a protection circuit for a power rail with the same. The latch protection switch includes: a first switch circuit for controlling its on-off state according to the value of its input voltage; a second switch circuit connected to the first switch circuit and used to control its own on-off state according to the on-off state of the first switch circuit, and after the second switch circuit is turned on, it will continue to conduct until a preset condition is met and then disconnect; a third switch circuit connected to the second switch circuit and used to control its own on-off state according to the on-off stateof the second switch circuit to control whether its output pin outputs voltage. The latch protection switch provided by the invention, through the cascade connection of three switch circuits, controls whether a voltage is output, thereby avoiding the situation of excessive heating due to short circuit due to high current, or even fire, and improves the safety of the circuit.

## Description

### Technical field

The invention relates to the technical field of electronic circuits, and in particular to a latch protection switch and a protection circuit for a power rail having the same.

### Background art

With the development of lighting technology, the demand for lighting on shelves is also increasing. Due to the different parameters such as the number of shelves and length, the wiring and installation requirements for lighting circuits are getting higher and higher, so the power rail came into being. On the one hand, the power rail simplifies wiring and beautifies the appearance of the shelves. On the other hand, it also reduces the difficulty of installation and wiring and improves maintenance efficiency. Most of the existing rails on the market are simple shells with electrical copper strips, or simple combinations of wire harnesses and connectors. Due to the complex shelf application environment, especially commercial shelves in supermarkets that need to be cleaned regularly, and freezer lights, are prone to short-circuits through moisture. Movement, bending, collision, etc. can also easily cause short circuits. Without good design and protection, this may lead to serious safety problems, especially for power rails with exposed copper strips. When there are water stains remaining on the positive and negative poles, in extreme cases, this may cause a short circuit. If there are no timely protection measures, the large current may cause the copper strip to continue to heat up and even cause a fire.

The existing technology mainly uses short-circuit protection for power supplies. However, in actual use, the position of the short-circuit caused by water damage is not fixed and the short-circuit caused by it is a slowly changing process. Moreover, our actual application is to use a large power supply with several rails. The short circuit of a single rail may not reach the protection point of the large power supply. If the protection circuit is not triggered, this will cause continuous heating and may even cause a fire.

### Summary of invention

In view of this, the present invention provides a latch protection switch and a power rail protection circuit having the same, which solves the problems of the existing power rail short circuit position being not fixed and generating large amounts of heat when a slow short circuit occurs.

In order to achieve the above objects, the present invention provides the following technical solutions:
In a first aspect, an embodiment of the present invention provides a latch protection switch. The latch protection switch includes:
a first switch circuit used to control its own on-off state according to the value of its input voltage;
a second switch circuit connected to the first switch circuit and used to control its own on-off state according to the on-off of the first switch circuit. After the second switch circuit is turned on, it will continue to conduct until preset conditions are met and then disconnect;
a third switch circuit connected to the second switch circuit and is used to control its own on-off according to the on-off of the second switch circuit to control whether its output pin outputs voltage.

The latch protection switch provided by the embodiment of the present invention, through the cascade of three switch circuits, controls whether the voltage is output, thereby avoiding the occurrence of short circuits that may cause excessive heat during high-current operation, or even cause fires, and improve the safety of the circuit.

Optionally, the preset condition is: the output voltage of the first switching circuit is less than the conduction threshold of the second switching circuit.

When the second switch circuit is turned on, it will continue to be turned on until the output voltage of the first switch circuit, that is, the input voltage of the second switch circuit is less than its conduction threshold, then the second switch circuit will be turned off. This ensures that only after the fault is eliminated, the system can be restored after a power outage and restart, which improves safety.

Optionally, the first switch circuit includes: a second transistor, a second resistor and a third resistor, wherein the gate of the second transistor is connected to the input voltage and one end of the second resistor, the source of the second transistor is connected to one end of the third resistor, the other end of the third resistor is connected to the other end of the second resistor, and the drain of the second transistor is connected to ground.

Optionally, the first switch circuit further includes: a fourth capacitor, wherein the source of the second transistor is connected to one end of the fourth capacitor, and the other end of the fourth capacitor is connected to ground.

By connecting the gate of the second transistor to the input voltage, the second transistor controls its on-off state according to the level of the input voltage, thereby changing the output voltage of the first switch circuit. The circuit structure is simple and the on-off control is accurate.

Optionally, the second switch circuit includes: a unidirectional thyristor, a fourth resistor, a seventh resistor and a fifth resistor, wherein the control electrode of the unidirectional thyristor is connected to the source electrode of the second transistor through the seventh resistor. The anode of the unidirectional thyristor is connected to the power supply through the fourth resistor in series, the cathode of the unidirectional thyristor is connected to ground, and a fifth resistor is connected in parallel between the cathode and the anode of the unidirectional thyristor.

Optionally, the second switch circuit further includes: a second Zener diode and a fourth surge protector, wherein the second Zener diode is connected between the fourth resistor and the power supply, and the fourth surge protector is connected in parallel to both ends of the fifth resistor.

The second switch circuit makes use of the characteristic that once the unidirectional thyristor is turned on, it can only be turned off by removing the load or reducing the voltage at both ends. This ensures that after the second switch circuit is turned on due to overload or short circuit, it can only be restored after the fault is removed and the power is turned off and restarted, which improves the safety of the circuit.

Optionally, the third switch circuit includes: a first transistor, an output interface, and a fourteenth resistor, wherein the gate of the first transistor is connected to the anode of the unidirectional thyristor, the source and power supply of the first transistor are respectively connected to the two pins of the output interface, and the fourteenth resistor is connected in parallel between the two pins of the output interface.

Optionally, the third switch circuit further includes: a second surge protector and a fifth surge protector, wherein the second surge protector and the fifth surge protector are connected in series between the source and drain of the first transistor.

The third switch circuit is connected to the anode of the unidirectional thyristor through the gate of the first transistor, and controls its on-off state according to the on-off state of the unidirectional thyristor. The source output of the first transistor controls whether the first plug has an output voltage. This ensures the safety of the output power supply.

Optionally, when the input voltage of the first switch circuit is high level, the second transistor is turned on, the unidirectional thyristor is turned off, the first transistor is turned on, and the two pins of the output interface output voltage; when the input level of the first switch circuit is low level, the second transistor is turned off, the one-way thyristor is turned on, the first transistor is turned off, and the two pins of the output interface do not output voltage.

Optionally, after the unidirectional thyristor is turned on, it will continue to be turned on until the input voltage of the unidirectional thyristor is less than the conduction threshold and then turns off.

The latch protection switch provided by the embodiment of the present invention takes advantage of the characteristic that once the unidirectional thyristor is turned on, it can only be turned off by removing the load or reducing the voltage at both ends. This ensures that after the second switch circuit is turned on due to overload or short circuit, it can only be restored after the fault is removed and the power is turned off and restarted, which improves the safety of the circuit.

In a second aspect, an embodiment of the present invention provides a protection circuit for a power rail, which is connected between the input end and the output end of the power rail, and includes: a voltage stabilizing module, a current sampling module, and any one of the latch protection switches as described regarding the first aspect, wherein:
the voltage stabilizing module is connected to the input end of the power rail and is used to stabilize the voltage at the input end of the power rail to a preset voltage and then supply power to the current sampling module and the protection circuit;
the current sampling module, connected to the voltage stabilizing module, is used to collect the current value on the power rail, and output a high level or a low level according to the current value;
the latch protection switch is connected to the current sampling module and is used to control whether the output end of the power rail outputs voltage according to the high level or low level.

The protection circuit for the power rail provided by the embodiment of the present invention stabilizes the input voltage at a preset voltage through the voltage stabilizing module to provide power for the electronic components in the protection circuit. The current sampling module is used to collect the current value on the power rail. It determines whether the power rail is faulty, and finally controls whether to output voltage through the latch protection switch to ensure the safety of power consumption on the power rail.

Optionally, the voltage stabilizing module includes: a first surge protector, a third surge protector, an input interface, a first diode, a first resistor, a first Zener diode, a first capacitor and a second capacitor, wherein:
the input interface is connected to the power rail;
the first surge protector and the third surge protector are connected in series and connected to two pins of the input interface, one end of the input interface is connected to the latch protection switch and the anode of the first diode, the cathode of the first diode are connected to one end of the first resistor, the other end of the first resistor is connected to the cathode of the first Zener diode, the current sampling module and the latch protection switch, the anode of the first Zener diode is connected to the other end of the input interface, both are grounded at the same time, the first capacitor and the second capacitor are connected in parallel with the first Zener diode respectively.

The voltage stabilizing module stabilizes the input voltage at a preset voltage and supplies power to the electronic components in the protection circuit of the power rail to ensure the normal operation of the protection circuit.

Optionally, the current sampling module includes: a comparator, a ninth resistor, a sixth resistor and a third capacitor, wherein:
the third capacitor and the sixth resistor form a filter circuit, and the filter circuit is connected in parallel with the ninth resistor, the first input pin and the second input pin of the comparator are connected in parallel with the third capacitor, the first input pin is grounded at the same time, the connection point of the sixth resistor and the ninth resistor is connected to the latch protection switch, and the output pin of the comparator is connected to the latch protection switch, the current value on the power rail is collected and converted into a voltage value, and the input voltage is provided to the latch protection switch after comparison by the comparator.

The current sampling module uses a constant current and constant voltage controller to collect the current value on the power rail, converts it into voltage and compares it through the internal voltage comparator, outputs high and low levels, and after the current value is processed, it is easy for the latch protection switch to controls the on-off state accordingly, thereby achieving the purpose of improving circuit safety.

### Brief description of the drawings

In order to more clearly explain the specific embodiments of the present invention or the technical solutions in the prior art, the accompanying drawings that need to be used in the description of the specific implementations or the prior art will be briefly introduced below. Obviously, the drawings in the following description illustrate some embodiments of the present invention. For those of ordinary skill in the art, other drawings can be obtained based on these drawings without any inventive activity.
Fig. 1 is a schematic structural diagram of a latch protection switch provided by an embodiment of the present invention;
Fig. 2 is a schematic circuit diagram of a latch protection switch provided by an embodiment of the present invention;
Fig. 3 is a schematic circuit diagram of a protection circuit for a power rail with a latch protection switch provided by an embodiment of the present invention.

### Description of embodiments

In order to make the purpose, technical solutions and advantages of the embodiments of the present invention clearer, the technical solutions in the embodiments of the present invention will be clearly and completely described below in conjunction with the drawings in the embodiments of the present invention. Obviously, the described embodiments are some examples of the present invention, rather than all embodiments. Based on the embodiments of the present invention, all other embodiments obtained by those skilled in the art without exercising inventive activity fall within the scope of protection of the present invention.

In the description of the present invention, it should be noted that when the terms "center", "upper", "lower", "left", "right", "vertical", "horizontal", "inner", "outer", etc. are used, the indicated orientation or positional relationship is based on the orientation or positional relationship shown in the drawings. It is only for the convenience of describing the present invention and simplifying the description. It does not indicate or imply that the device or element referred to must have a specific orientation or be in a specific orientation, construction and operation, and therefore should not be construed as limitations of the invention. Furthermore, the terms "first", "second" and "third" are used for descriptive purposes only and are not to be construed as indicating or implying relative importance.

In the description of the present invention, it should be noted that, unless otherwise clearly stated and limited, the terms "installed", "connected" and "linked" should be understood in a broad sense. For example, it can be a fixed connection, a detachable connection or an integral connection; it can be a mechanical connection or an electrical connection; it can be a direct connection or an indirect connection through an intermediary; it can also be an internal connection between two components; it can be a wireless connection or a wired connection. For those of ordinary skill in the art, the specific meanings of the above terms in the present invention can be understood according to specific circumstances.

The technical features involved in different embodiments of the present invention described below can be combined with each other as long as they do not conflict with each other.

### Embodiment 1

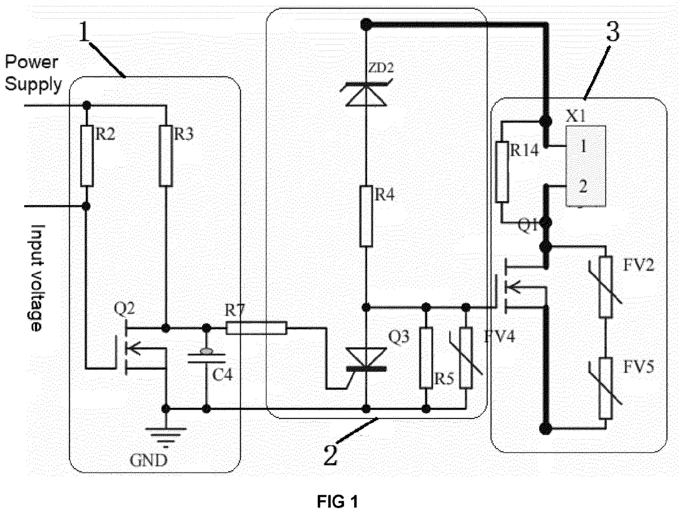

An embodiment of the present invention provides a latch protection switch. As shown in Fig. 1, the latch protection switch includes:
a first switch circuit 1 used to control its on-off state according to the value of its input voltage.
a second switch circuit 2 connected to the first switch circuit 1 and used to control its own on-off state according to the on-off state of the first switch circuit 1. After the second switch circuit 2 is turned on, it will continue to conduct until a preset condition is met and then disconnect. Specifically, in one embodiment, the preset condition is: the output voltage of the first switch circuit 1 is less than the conduction threshold of the second switch circuit 2. After the second switch circuit 2 is turned on, it will continue to conduct until the output voltage of the first switch circuit 1, that is, the input voltage of the second switch circuit 2 is less than its conduction threshold, then the second switch circuit 2 will be turned off. This ensures that the system can only be restored after the fault is removed and the power is turned off and restarted, which improves safety.

The third switch circuit 3 is connected to the second switch circuit 2 and is used to control its own on-off state according to the on-off state of the second switch circuit 2 to control whether its output pin outputs voltage.

The latch protection switch 33 provided by the embodiment of the present invention controls whether it outputs voltage through the cascade of three switch circuits, thereby avoiding short circuits that may cause excessive heat due to high currents, or even cause fires, and improves the safety of the circuit.

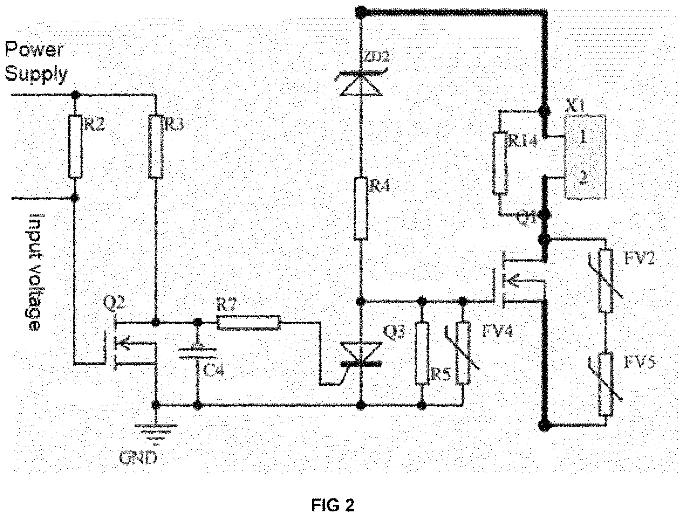

Specifically, in one embodiment, as shown in Fig. 2, the first switch circuit 1 includes: a second transistor Q2, a second resistor R2 and a third resistor R3, wherein the gate of the second transistor Q2 is connected to the input voltage and one end of the second resistor R2, and the source of the second transistor Q2 is connected to one end of the third resistor R3. The other end of the third resistor R3 is connected to the other end of the second resistor R2. The drain of the second transistor Q2 is connected to ground. In a specific embodiment, the first switch circuit 1 further includes: a fourth capacitor C4, one end of the fourth capacitor C4 is connected to the source of the second transistor Q2, and the other end of the fourth capacitor C4 is connected to ground.

By connecting the gate of the second transistor Q2 to the input voltage, the second transistor Q2 controls its on-off state according to the level of the input voltage, thereby changing the output voltage of the first switching circuit 1. The circuit structure is simple and the on-off control is accurate.

Specifically, in one embodiment, as shown in Fig. 2, the second switch circuit 2 includes: a unidirectional thyristor Q3, a fourth resistor R4, a seventh resistor R7 and a fifth resistor R5, wherein the control electrode of the unidirectional thyristor Q3 is connected to the source of second transistor Q2 through the seventh resistor R7. The anode of unidirectional thyristor Q3 is connected to the power supply after being connected in series with the fourth resistor R4 (the thick black line in Fig. 2 represents the power bus). The cathode of the thyristor Q3 is grounded, and the fifth resistor R5 is connected in parallel between the cathode and anode of the unidirectional thyristor Q3. In a specific embodiment, the second switch circuit 2 further includes: a second Zener diode ZD2 and a fourth surge protector FV4. The second Zener diode ZD2 is connected between the fourth resistor and the power supply. The fourth surge protector FV4 is connected in parallel across the fifth resistor.

The second switch circuit 2 makes use of the characteristic that once the unidirectional thyristor is turned on, it can only be turned off by removing the load or reducing the voltage at both ends of the thyristor. This ensures that after an overload or short circuit causes the second switch circuit 2 to turn on, it can only be restored after the fault is removed and the power is turned off and restarted, which improves safety.

Specifically, in one embodiment, as shown in Fig. 2, the third switch circuit 3 includes: a first transistor Q1, an output interface X1 (a plug is often used as an output interface to connect to a peripheral output circuit), and a fourteenth resistor R14, wherein the gate of the first transistor Q1 is connected to the anode of the unidirectional thyristor Q3, the source and power supply of the first transistor Q1 are respectively connected to the two pins of the output interface X1, and the two pins of the output interface X1 are connected in parallel to the fourteenth resistor R14.

In a specific embodiment, the third switch circuit 3 further includes: a second surge protector FV2 and a fifth surge protector FV5. The second surge protector FV2 and the fifth surge protector FV5 are connected in series. The source and drain of the first transistor Q1 serve as double insurance.

The third switch circuit 3 is connected to the anode of the unidirectional thyristor Q3 through the gate of the first transistor Q1, and controls its own on-off state according to the on-off state of the unidirectional thyristor Q3. The source output of the first transistor Q1 controls the output interface X1 whether to output voltage to ensure the safety of the output power supply.

Specifically, in one embodiment, when the input voltage of the first switch circuit 1 is high level, the second transistor Q2 is turned on, the unidirectional thyristor Q3 is turned off, the first transistor Q1 is turned on, and the two output interface pins output voltage. When the input voltage of the first switch circuit 1 is low level, the second transistor Q2 is turned off, the unidirectional thyristor Q3 is turned on, the first transistor Q1 is turned off, and the two pins of the output interface do not output voltage.

For example, after the unidirectional thyristor Q3 is turned on, it will continue to be turned on until the input voltage of the unidirectional thyristor Q3 is less than the conduction threshold and turns off. The conduction of the unidirectional thyristor requires a sustaining current. The size of the sustaining current is related to the chip model. The current is provided through the voltage. Therefore, in the embodiment of the present invention, the conduction threshold of the unidirectional thyristor Q3 refers to the amount of current that can be used for the unidirectional thyristor Q3. If an input voltage value is provided to maintain current to thyristor Q3, once the unidirectional thyristor Q3 is turned on, as long as the input voltage exists, regardless of whether the output of the second transistor Q2 is high level or low level, the unidirectional thyristor Q3 will continue to be turned on, and the first transistor Q1 will be latched at this time. The lock is closed. Only when the power is turned off and the holding current provided by the input voltage of the unidirectional thyristor Q3 is insufficient to maintain its conduction, will the unidirectional thyristor Q3 be released from the latch shutdown, so that the first transistor Q1 is turned on again. This realizes the function of latch closing the output after a fault occurs.

The latch protection switch provided by the embodiment of the present invention takes advantage of the characteristic that once the unidirectional thyristor is turned on, it can only be turned off by removing the load or reducing the voltage at both ends, ensuring that after overload or short circuit causes the second switch circuit to turn on, , it can only be restored after power outage troubleshooting and restarting, which improves the safety of the circuit.

### Embodiment 2

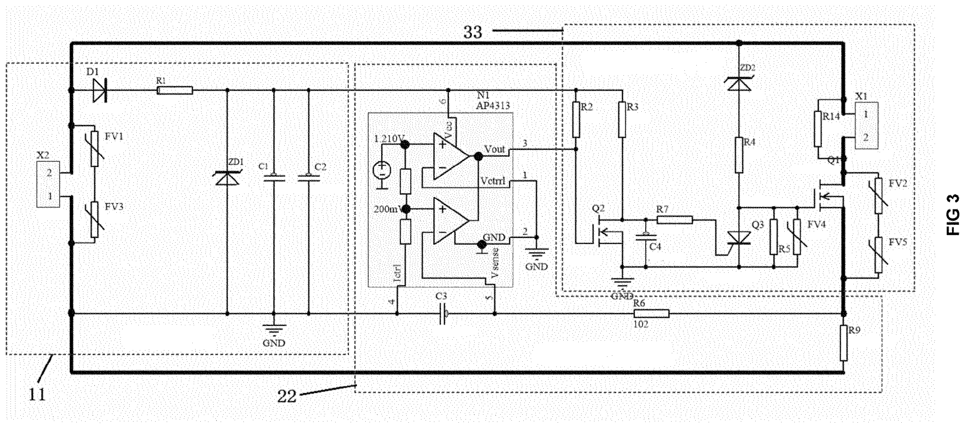

The embodiment of the present invention provides a protection circuit for a power rail, which is connected between the input end and the output end of the power rail, as shown in Fig. 3, including: a voltage stabilizing module 11, a current sampling module 22 and any one of the latch protection switches 33 according to embodiment 1, wherein:
the voltage stabilizing module 11 is connected to the input end of the power rail, and is used to stabilize the voltage at the input end of the power rail to a preset voltage and then supply power to the current sampling module 22 and the protection circuit. For example, the voltage stabilizing module 11 is mainly used to stabilize the 12V or 24V voltage of the input line to 5.6V, and is used to provide power to the following comparator N1. For the comparator N1 a constant voltage and constant current controller model AP4313 is selected as an example, but not limited to this.

The current sampling module 22 is connected to the voltage stabilizing module 11 and is used to collect the current value on the power rail and output a high level or a low level according to the current value. Exemplarily, the current sampling module 22 mainly converts the current of the loop where the ninth resistor R9 is located into a voltage through the sampling resistor (i.e., the ninth resistor R9) connected in series in the loop and through the filtering of the sixth resistor R6 and the third capacitor C3. Then comparison is made through the voltage comparator inside the comparator N1. There is a comparison voltage of 200mV inside the comparator N1. When the voltage value obtained after the loop current is converted by the ninth resistor R9 is greater than 200mV, the output pin of the comparator N1 outputs low level, otherwise it outputs high level.

The latch protection switch 33 is connected to the current sampling module 22 and is used to control whether the output end of the power rail outputs voltage according to the high level or the low level. For example, when the load is normal, that is, the voltage value obtained after the loop current is converted by the ninth resistor R9 is not greater than the comparison voltage 200mV, the output pin of the comparator N1 outputs a high level, the second transistor Q2 is turned on, and the unidirectional thyristor Q3 is turned off, the first transistor Q1 is turned on, and the first plug outputs a normal voltage; when the loop is overloaded or short-circuited, the voltage value obtained after the loop current converted by the ninth resistor R9 is greater than the comparison voltage of 200mV, and the output pin of comparator N1 outputs a low level, the second transistor Q2 is turned off, the unidirectional thyristor Q3 is turned on, the first transistor Q1 is turned off, and the first plug does not output voltage.

The protection circuit for the power rail provided by the embodiment of the present invention stabilizes the input voltage at a preset voltage through the voltage stabilizing module 11 to provide power for the electronic components in the protection circuit. The current sampling module 22 is used to collect the current value on the power rail, determines whether the power rail is faulty, and finally controls whether to output voltage through the latch protection switch 33, ensuring the safety of power consumption on the power rail.

Specifically, in one embodiment, the voltage stabilizing module 11 includes: a first surge protector FV1, a third surge protector FV3, an input interface X2, a diode D1, a first resistor R1, a first voltage stabilizing diode ZD1, a first capacitor C1 and a second capacitor C2, the input interface X2 (a plug is often used as the input interface to connect the peripheral circuit) is connected to the power rail; the first surge protector FV1 and the third surge protector FV3 are connected in series with the two pins of the input interface X2. One end of the input interface, the cathode of the voltage diode ZD1, the current sampling module 22 and the latch protection switch 33 are connected. The anode of the first Zener diode ZD1 is connected to the other end of the input interface X2. Both are grounded at the same time. The first capacitor C1 and the second capacitor C2 are connected in parallel to the Zener diode ZD1.

The voltage stabilizing module 11 stabilizes the input voltage at a preset voltage and supplies power to the electronic components in the protection circuit of the power rail to ensure the normal operation of the protection circuit.

Specifically, in one embodiment, the current sampling module 22 includes: a comparator N1, a ninth resistor R9, a sixth resistor R6 and a third capacitor C3, wherein the third capacitor C3 and the sixth resistor R6 form a filter circuit. The circuit is connected in parallel with the ninth resistor R9. The first input pin Ictrl and the second input pin Vsense of the comparator N1 are connected in parallel with the third capacitor C3. The first input pin Ictrl is grounded at the same time. The sixth resistor R6 and the ninth resistor R9 are connected in parallel. The connection point is connected to the latch protection switch 33, and the output pin Vout of the comparator N1 is connected to the latch protection switch 33. The current value on the power rail is collected and converted into a voltage value, and is compared with the comparator to provide input voltage to the latch protection switch 33.

The current sampling module 22 uses a constant current and constant voltage controller to collect the current value on the power rail, converts it into voltage, compares it through the internal voltage comparator, outputs high and low levels, and processes the current value to allow the latch protection switch 33 to controll its on-off state accordingly, thereby achieving the purpose of improving circuit safety.

Although the embodiments of the present invention have been described in conjunction with the accompanying drawings, those skilled in the art can make various modifications and variations without departing from the spirit and scope of the invention. Such modifications and variations are covered by the appended claims.

## Claims

1. A latch protection switch, **characterized in that** it includes:
a first switch circuit (1) used to control its own on-off state according to the value of its input voltage;
a second switch circuit (2) connected to the first switch circuit (1), and used to control its own on-off state according to the on-off state of the first switch circuit (1), and after the second switch circuit (2) is turned on, it will continue to conduct until a preset condition is met and then disconnect;
a third switch circuit (3) connected to the second switch circuit (2) and used to control its own on-off state according to the on-off stateof the second switch circuit (2) to control whether its output pin outputs voltage.

2. The latch protection switch according to claim 1, **characterized in that** the preset condition is: the output voltage of the first switch circuit (1) is less than the conduction threshold of the second switch circuit (2).

3. The latch protection switch according to claim 2, **characterized in that** the first switch circuit (1) includes: a second transistor (Q2), a second resistor (R2) and a third resistor (R3), wherein
the gate of the second transistor (Q2) is connected to the input voltage and one end of the second resistor (R2), the source of the second transistor (Q2) is connected to one end of the third resistor (R3), the other end of the third resistor (R3) is connected to the other end of the second resistor (R2), and the drain of the second transistor (Q2) is connected to ground.

4. The latch protection switch according to claim 3, **characterized in that** the second switch circuit (2) includes: a unidirectional thyristor (Q3), a fourth resistor (R4), a seventh resistor (R7) and a fifth resistor (R5), wherein
the control electrode of the unidirectional thyristor (Q3) is connected to the source of the second transistor through the seventh resistor (R7), the anode of the unidirectional thyristor (Q3) is connected to the power supply through the fourth resistor (R4) in series, the cathode of the unidirectional thyristor (Q3) is connected to ground, and a fifth resistor (R5) is connected in parallel between the cathode and anode of the unidirectional thyristor (Q3).

5. The latch protection switch according to claim 4, **characterized in that** the third switch circuit (3) includes: a first transistor (Q1), an output interface (X1), and a fourteenth resistor (R14), wherein
the gate of the first transistor (Q1) is connected to the anode of the unidirectional thyristor, the source and power supply of the first transistor (Q1) are respectively connected to the two pins of the output interface (X1), and the fourteenth resistor (R14) is connected in parallel between the two pins of the output interface (X1).

6. The latch protection switch according to claim 5, **characterized in that**,
when the input voltage of the first switch circuit (1) is high level, the second transistor (Q2) is turned on, the unidirectional thyristor (Q3) is turned off, the first transistor (Q1) is turned on, and the two pins of the output interface (X1) output voltage;
when the input voltage of the first switch circuit (1) is low level, the second transistor (Q2) is turned off, the unidirectional thyristor (Q3) is turned on, the first transistor (Q1) is turned off, and the two pins of the output interface (X1) do not output voltage.

7. The latch protection switch according to claim 3, **characterized in that** the first switch circuit (1) further includes: a fourth capacitor (C4), wherein the source of the second transistor (Q2) is connected to one end of the fourth capacitor (C4), and the other end of the fourth capacitor (C4) is connected to ground.

8. The latch protection switch according to claim 4, **characterized in that** the second switch circuit (2) further includes: a second Zener diode (ZD2) and a fourth surge protector (FV4), wherein the second Zener diode (ZD2) is connected between the fourth resistor (R4) and the power supply, and the fourth surge protector (FV4) is connected in parallel to both ends of the fifth resistor (R5).

9. The latch protection switch according to claim 5, **characterized in that** the third switch circuit (3) further includes: a second surge protector (FV2) and a fifth surge protector (FV5), wherein the the second surge protector (FV2) and the fifth surge protector (FV5) are connected in series between the source and drain of the first transistor (Q1).

10. A protection circuit for a power rail, **characterized in that** it is connected between the input end and the output end of the power rail, and includes: a voltage stabilizing module (11), a current sampling module (22) and a latch protection switch (33) as described in any one of claims 1 to 9, wherein:
the voltage stabilizing module (11) is connected to the input end of the power rail and is used to stabilize the voltage at the input end of the power rail to a preset voltage and then supply power to the current sampling module (22) and the protection circuit;
the current sampling module (22) is connected to the voltage stabilizing module (11), used to collect the current value on the power rail, and output a high level or a low level according to the current value;
the latch protection switch (33) is connected to the current sampling module (22) and is used to control whether the output end of the power rail outputs voltage according to the high level or low level.

11. The protection circuit for a power rail according to claim 10, **characterized in that** the voltage stabilizing module (11) includes: a first surge protector (FV1), a third surge protector (FV3), an input Interface (X2), a first diode (D1), a first resistor (R1), a first Zener diode (ZD1), a first capacitor (C1) and a second capacitor (C2), wherein:
the input interface (X2) is connected to the power rail;
the first surge protector (FV1) and the third surge protector (FV3) are connected in series and connected to the two pins of the input interface (X2), one end of the input interface (X2) is connected to the latch protection switch (33), the anode of the first diode (D1) and the cathode of the first diode (D1) are connected to one end of the first resistor (R1), the other end of the first resistor (R1) is connected to cathode of the first Zener diode (ZD1), the current sampling module (22) and the latch protection switch (33), the anode of the first Zener diode (ZD1) is connected to the other end of the input interface (X2), both are grounded at the same time, the first capacitor (C1) and the second capacitor (C2) are connected in parallel with the first Zener diode (ZD1) respectively.

12. The protection circuit for a power rail according to claim 10, **characterized in that** the current sampling module (22) includes: a comparator (N1), a ninth resistor (R9), a sixth resistor (R6) and a third capacitor (C3), wherein:
the third capacitor (C3) and the sixth resistor (R6) form a filter circuit, and the filter circuit is connected in parallel with the ninth resistor (R9), the first input pin and the second input pin of the comparator (N1) are connected in parallel with the third capacitor (C3), the first input pin is grounded at the same time, the connection point of the sixth resistor (R6) and the ninth resistor (R9) is connected to the latch protection switch (33), and the output pin of the comparator (N1) is connected to the latch protection switch (33), the current value on the power rail is collected and converted into a voltage value, and the input voltage is provided to the latch protection switch (33) after comparison by the comparator (N1).
